(19) Europäisches Patentamt
European Patent Office
Office européen des brevets

(11) Veröffentlichungsnummer: **0 059 325**
**A1**

# (12) EUROPÄISCHE PATENTANMELDUNG

(21) Anmeldenummer: **82100674.9**

(22) Anmeldetag: **30.01.82**

(51) Int. Cl.³: **C 08 F 8/42**
C 08 F 8/48, H 01 B 1/12
H 01 L 29/28, H 01 L 31/02

(30) Priorität: **14.02.81 DE 3105450**

(43) Veröffentlichungstag der Anmeldung:
**08.09.82 Patentblatt 82/36**

(84) Benannte Vertragsstaaten:
**BE DE FR GB NL**

(71) Anmelder: **BASF Aktiengesellschaft**
**Carl-Bosch-Strasse 38**
**D-6700 Ludwigshafen(DE)**

(72) Erfinder: **Naarmann, Herbert, Dr.**
**Haardtblick 15**
**D-6719 Wattenheim(DE)**

(72) Erfinder: **Penzien, Klaus, Dr.**
**Bensheimer Ring 18**
**D-6710 Frankenthal(DE)**

(72) Erfinder: **Heckmann, Walter, Dr.**
**Geiersbergstrasse 2**
**D-6940 Weinheim(DE)**

(72) Erfinder: **Simak, Petr, Dr.**
**Philipp-Scheidemann-Strasse 17**
**D-6700 Ludwigshafen(DE)**

## (54) Verfahren zur Herstellung elektrisch leitfähiger Polymeren und deren Verwendung in der Elektrotechnik und zur antistatischen Ausrüstung von Kunststoffen.

(57) Die Erfindung betrifft ein Verfahren zur Herstellung elektrisch leitfähigen Polymeren mit elektrischen Leitfähigkeiten größer als $10^{-2}$ S/cm, wobei Polymerisate des Propargylalkohols mit einem Dehydratisierungsmittel zu Polymeren dehydratisiert und anschließend mit einer Lewis-Säure in Mengen von 0,1 bis 70 Gewichtsprozent umgesetzt werden. Besonders geeignet als Dehydratisierungsmittel sind Phosphorpentoxid, Kaliumbisulfat, Phosphorsäure oder ein Metalloxid, insbesondere Aluminium-, Magnesium-, Eisen-, Zinn- oder Antimonozid und als Lewis-Säure ein Halogenderivat von Elementen der II., IV., V., VI., VII. oder VIII. Gruppe des Periodensystems.

Die hergestellten elektrisch leitfähigen Polymeren können in der Elektrotechnik zur Herstellung von Sonnenzellen, zur Umwandlung und Fixierung von Strahlung, zur Herstellung elektrischer und magnetischer Schalter und elektrischer Speicher und zur antistatischen Ausrüstung von Kunststoffen verwendet werden.



Croydon Printing Company Ltd.

Verfahren zur Herstellung elektrisch leitfähiger Polymeren und deren Verwendung in der Elektrotechnik und zur antistatischen Ausrüstung von Kunststoffen

Die Erfindung betrifft ein Verfahren zur Herstellung von elektrisch leitfähigen Polymeren mit elektrischen Leitfähigkeiten größer als $10^{-2}$ S/cm aus Polymerisaten des Propargylalkohols.

Bei derartigen Verfahren sind Zusätze erforderlich, um eine elektrische Leitfähigkeit bei den Polymeren zu bewirken.

Es ist bereits in der deutschen Patentanmeldung P 31 00 581 vorgeschlagen worden, Propargylalkohol mit oxidierend wirkenden Lewis-Säuren in Mengen von 1 bis 50 Gewichtsprozent umzusetzen. Bei dieser Umsetzung entstehen elektrisch leitfähige Polymere. Bei dem vorgeschlagenen Verfahren muß bei relativ niedrigen Temperaturen umgesetzt werden.

Es ist auch bereits bekannt, elektrisch leitfähige Polymere durch oxidative Kupplung von aromatischen Verbindungen mit Hilfe von Lewis-Säuren herzustellen (vgl. "Naturwissenschaften 56, (1969), Seite 308). Dieses Verfahren wurde jedoch nur bei aromatischen und cycloaliphatischen Systemen durchgeführt. Die erhaltenen Polymeren waren relativ niedermolekular mit Polymerisationsgraden bis zu ca. 50 und dementsprechend spröde und schwer zu verarbeiten.

Der Erfindung lag die Aufgabe zugrunde, nach einfacher chemischer Verfahrensweise elektrisch leitfähige Polymere mit Leitfähigkeiten größer als $10^{-2}$ S/cm zu schaffen, wobei von fertigen Vorpolymerisaten ausgegangen werden soll.

Rss/P

Die Aufgabe wurde dadurch gelöst, daß Polymerisate des Propargylalkohols mit einem Dehydratisierungsmittel zu Polymeren dehydratisiert und anschließend mit einer Lewis-Säure in Mengen von 0,1 bis 70, vorzugsweise 5 bis 35 Gewichtsprozent, bezogen auf das dehydratisierte Polymere, umgesetzt werden. Das Dehydratisierungsmittel ist bevorzugt Phosphorpentoxid, Kaliumbisulfat, Phosphorsäure oder Aluminium-, Magnesium-, Eisen-, Zinn- oder Antimonoxid, die Lewis-Säure ist bevorzugt ein Halogenderivat von Elementen der III., IV., V., VI., VII. oder VIII. Gruppe des Periodensystems der Elemente. Das Polymerisat des Propargylalkohols wird bevorzugt zu dem Polymeren der allgemeinen Formel:

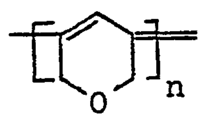

,

wobei n = 5 bis 200, dehydratisiert.

Unter elektrisch leitfähigen Polymeren mit elektrischen Leitfähigkeiten größer als $10^{-2}$ S/cm werden Substanzen verstanden, die nach der Meßmethode von F. Beck, Berichte der Bunsengesellschaft 68, (1964), Seite 559 eine elektrische Leitfähigkeit von über $10^{-2}$ S/cm aufweisen.

Die Polymerisate des Propargylalkohols, welche erfindungsgemäß zur Anwendung kommen, werden hergestellt nach den Angaben der Literaturstelle US-PS 3 092 613, insbesondere Beispiel 23. Die Herstellung der Ausgangspolymerisate ist nicht Gegenstand der Erfindung, es wird jedoch zweckmäßig anstelle von Nickelbromid-Trihydrat mit Nitraten, Chloriden, Acetylacetonaten und mit Kobalt als Metallion gearbeitet. Als Reduktionsmittel wird vorzugsweise statt des Natriumborhydrids Lithiumborhydrid oder Lithiumalanat verwendet, auch Phosphite, Phosphine sowie Hypophosphite sind anstelle der im US-Patent angegebenen Natriumborhy-

dride einsetzbar.

Nach erfindungsgemäßem Verfahren werden die bekannten Polymerisate des Propargylalkohols mit den Dehydratisierungsmitteln Phosphorpentoxid, Kaliumbisulfat, Phosphorsäure, $Al_2O_3$, MgO, $Fe_3O_4$, $SnO_2$ oder $Sb_2O_3$ umgesetzt, wobei ein dehydratisiertes Polymer, das bevorzugt die Verbindung:

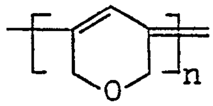

, wobei n = 5 bis 200

ist, entsteht. Hierzu kann man die Polymerisate des Propargylalkohols, die gemäß US-PS-3 926 613, hergestellt wurden, bevorzugt in Gegenwart von 1 bis 30 Gewichtsprozent Metalloxid als Dehydratisiermittel 0,1 bis 5 Stunden auf 100 bis 550°C erhitzen und das erhaltene dehydratisierte Polymere mit Wasser bis zur Neutralreaktion waschen.

Das so gewonnene Polymere wird dann mit 0,1 bis 70, bevorzugt 5 bis 35 Gewichtsprozent, bezogen auf das dehydratisierte Polymere, einer Lewis-Säure versetzt. Bevorzugt wird erfindungsgemäß als Lewis-Säure ein Halogenderivat von Elementen der III., IV., V., VI., VII. oder VIII. Gruppe des Periodensystems der Elemente verwendet.

Nach besonders bevorzugter Verfahrensweise wird als Lewis-Säure die Verbindung $AsF_5$, $SbF_5$, $UF_6$, $SbCl_5$, $AlCl_3$, $BF_3$, $SbF_5$, $FeCl_3$, $CF_3SO_3H$, $VOCl_3$, $HClO_4$, $NO^+SbF_6^-$, $NO_2^+SbF_6^-$, $NO^+AsF_6^-$, $XeF_4$, $NO^+PF_6^-$, $I_2$, $Br_2$, ICl, $PF_5$, $CrO_2Cl_2$, $NO_2^+PF_6^-$, $NO^+BF_4^-$, $NO^+ClO_4^-$, $(CF_3)_2SO_4$, $NbF_5$, $TaF_5$, $WF_6$, $FeCl_3$, $CdCl_2$ oder $BF_3/CrOCl_2$ eingesetzt.

Als Lewis-Säuren nach dem erfindungsgemäßen Verfahren kommen ferner in Frage:

Aus der

Gruppe VIII

$KrF_2$, $XeOF_4$, $XeF_6$, $XeO_2F_2$, $HXeO_4$ sowie der

Gruppe VII

$ClF_3$, $ClF_5$, $BrF_3$, $IF_5$, $IF_7$, BrCl, BrI, $Cl_2O$, $Cl_2O_3$, $ClO_2$, $ClOClO_3$, $Cl_2O_6$, $Cl_2O_6$, $Cl_2O_7$, $Br_2O$, $BrO_2$, $Br_2O_5$, $Br_3O_2$, $BrO_3$, $I_4O_5$, $I_2O_5$, HOCl, $HClO_2$, $HClO_3$, $HClO_4$, HOBr, $HBrO_2$, $HBrO_3$, $HBrO_4$, $HIO_3$, $HIO_4$, $FClO_3$, $ClF_3O$, $ClF_3O_2$, $FClO_2$, FClO, $BrO_2F$, $BrO_3F$, $IO_2F$, $IOF_3$, $IO_2F_3$, $IOF_5$ wie aus der

Gruppe VI

$FSO_3H$, $(FSO_3F)$, $R(SO_2F)$ mit R = NH, CH, $FXe(SO_3F)$, $FXe(OSeF_5)$, $FXe(OTeF_5)$, $Xe(OSeF_5)_4$, $Xe(OTeF_4)$, $FXe(OSeF_5)$, $F_{6-x}Cl(OSeF_5)_x$ mit x = 1 bis 5 $FW(OSeF_5)_x$ mit x = 1 bis 6,

sowie den

Nebengruppen

$AuF_5$, $PtF_6$, $IrF_6OSF_6$, $PtF_5$, $IrF_5$, $OsF_5$, $CrF_5$, $MoF_6$, $WF_5$, $MoF_5$, $VF_5$, $PuF_6$, $ReF_7$, $ReOF_5$, $CrO_2F_2$, $CrO_3$, $AuCl_3$, $PtCl_4$, $AuCl_3$

Es kommen ferner in Frage:

Aus der

VI. Gruppe

$CF_3(CF_2)_nSO_3H$, $ClSO_3H$, $Cl_2CHSO_3H$, sowie der

V. Gruppe

$HPO_2F_2$, $P_2O_3F_4$, $PF_5$, $BiX_3$ mit X = F, Cl, Br oder i.

IV. Gruppe

$SiF_4$, $H_2SiF_6$, $GeX_4$, $SnX_4$, $PbX_4$ mit X = F, Cl, Br der

III. Gruppe

$BX_3$, $AlX_3$, $GaX_3$, $TlX_3$ mit X = F, Cl, Br, I sowie der

Nebengruppen

$ReF_6$, $ReCl_5$, $ReCl_4$, $ReOF_4$, $VOF_3$, $NbOF_3$, $TaOF_3$, $VCl_3$,
$VF_3$, $NbCl_5$, $TaCl_5$, $NbOCl_3$, $TuOCl_3$, $UCl_5$,
$CuX_2$, AgX, AuX (X = Cl, Br)
$ZnX_2$, $CdX_2$, $HgX_2$ (X = Cl, Br, I)
NiX, $PdX_2$, $PtX_2$ (X = Cl, Br, I)
$CoX_2$, $RhX_2$, $IrX_2$(X = Cl, Br, I)
$FeX_2$, $FeX_3$, $RuX_2$, $OsX_2$ (X = Cl, Br, I)
$MnX_2$, (X = Cl, Br, I)
$TiX_4$, $ZrX_4$, $HfF_4$ (X = F, Cl, Br, I)
$SeX_3$, $Y_3X$, $LaX_3$ Lanthanide $X_3$ (X = F, Cl, Br, I)
Actinide $X_3$, $X_5$ (X = F, Cl, Br)

Die Reaktion kann mit den gasförmigen Reaktanten oder mit Hilfssäuren wie: HF, $HOSeF_5$, $HOTeF_5$, $CF_3SO_3H$, $CF_3COOH$, $CF_3PO_3H$, $(CF_3)_2$ POOH, $HPF_6$, $H_2SiF_6$, $H_2PO_2F_2$, oder in inerten Lösungsmitteln wie: $SO_2$, $SO_2Cl_2$, $SO_2F_2$, $SO_2ClF$, $CFCl_3$ HF, $CH_3CN$, $CH_3NO_2$ oder $C_2H_5NO_2$ durchgeführt werden.

Die erfindungsgemäß hergestellten elektrisch leitfähigen polymeren Systeme mit elektrischen Leitfähigkeiten größer als $10^{-2}$ S/cm sind zur antistatischen Ausrüstung von Kunststoffen, zur Herstellung von Sonnenzellen, zur Umwandlung und Fixierung von Strahlung sowie zur Herstellung elektrischer und magnetischer Schalter und elektrische Speicher geeignet. Durch die Zusätze der starken Lewis-Säure entstehen sog. p-Leiter (vgl. "Journal of Chemical. Education" 46, (1969), Nr. 2, Seite 82).

Die in den folgenden Beispielen genannten Teile sind Gewichtsteile.

Beispiele 1 bis 10

100 Teile oligomerer Propargylalkohol, hergestellt nach US-PS 3 092 613 (Beispiel 23), werden mit 20 Teilen siruposer Phosphorsäure versetzt und 3 Stunden bei 35°C zur Reaktion gebracht, anschließend wird mit Wasser gewaschen bis Neutralreaktion eingetreten ist. Das so gewonnene und getrocknete Polymere wird dann mit 10 Teilen $AsF_5$ versetzt. Hierdurch wird ein elektrisch leitfähiges Polymerisat erhalten. Werden Metalloxid als Dehydratisierungsmittel eingesetzt, so erfolgt das Dehydratisieren bei Temperaturen von

100 bis 550°C, vorzugsweise bei 150 bis 200°C. Vor dem Komplexieren werden die Metalloxid-Katalysatoren durch Säure ausgewaschen. Das verbleibende organische Polymere wird dann komplexiert.

In der folgenden Tabelle werden die Eigenschaften der erfindungsgemäß hergestellten Polymeren zusammengefaßt. Die in den folgenden Beispielen genannten Zahlen sind Gewichtsteile.

Tabelle

| Beispiel Nr. | Dehydratisierungsmittel Teile | Komplexierungsmittel Teile | elektr. Leitfähigkeit S/cm |
|---|---|---|---|
| 1 | 20 $H_3PO_4$ | 10 $AsF_5$ | $3{,}5 \cdot 10^{-2}$ |
| 2 | 20 $H_3PO_4$ | 20 $AsF_5$ | $5{,}6 \cdot 10^{-2}$ |
| 3 | 20 $H_3PO_4$ | 30 $AsF_5$ | $6{,}1 \cdot 10^{-1}$ |
| 4 | 30 $KHSO_4$ | 20 $SbF_5$ | $2{,}8 \cdot 10^{-2}$ |
| 5 | 20 MgO | 25 $HClO_4$ | $6{,}3 \cdot 10^{-1}$ |
| 6 | 20 $Fe_3O_4$ | 25 $FeCl_3$ | $3{,}8 \cdot 10^{-2}$ |
| 7 | 20 $Sb_2O_3$ | 25 $BF_3/10CrOCl_2$ | $4{,}9 \cdot 10^{-1}$ |
| 8 | 20 $SnO_2$ | 25 $XeF_4$ | $1{,}5 \cdot 10^{-1}$ |
| 9 | 20 $Al_2O_3$ | 25 $NbF_5$ | $1{,}7 \cdot 10^{-1}$ |

## Patentansprüche

1. Verfahren zur Herstellung von elektrisch leitfähigen Polymeren mit elektrischen Leitfähigkeiten größer als $10^{-2}$ S/cm aus Polymerisaten des Propargylalkohols, dadurch gekennzeichnet, daß Polymerisate des Propargylalkohols mit einem Dehydratisierungsmittel zu Polymeren dehydratisiert und anschließend mit einer Lewis-Säure in Mengen von 0,1 bis 70 Gewichtsprozent, bezogen auf das dehydratisierte Polymere, umgesetzt werden.

2. Verfahren nach Anspruch 1, dadurch gekennzeichnet, daß das Dehydratisierungsmittel Phosphorpentoxid, Kaliumbisulfat, Phosphorsäure oder Aluminium-, Magnesium-, Eisen-, Zinn- oder Antimonoxid ist.

3. Verfahren nach Anspruch 1, dadurch gekennzeichnet, daß das Polymerisat des Propargylalkohols zu dem Polymeren der allgemeinen Formel:

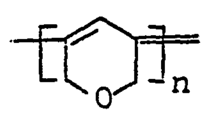 ,

wobei n = 5 bis 200, dehydratisiert wird.

4. Verfahren nach Anspruch 1, dadurch gekennzeichnet, daß die Lewis-Säure ein Halogenderivat von Elementen der III., IV., V., VI., VII. oder VIII. Gruppe des Periodensystems der Elemente ist.

5. Verfahren nach Anspruch 1, dadurch gekennzeichnet, daß mit einer Lewis-Säure in Mengen von 5 bis 35 Gewichtsprozent, bezogen auf das dehydratisierte Polymere umgesetzt wird.

6. Verwendung der nach Anspruch 1 hergestellten elektrisch leitfähigen Polymeren in der Elektrotechnik zur Herstellung von Sonnenzellen, zur Umwandlung und Fixierung von Strahlung und zur Herstellung elektrischer und magnetischer Schalter und elektrischer Speicher.

7. Verwendung der nach Anspruch 1 hergestellten elektrisch leitfähigen Polymeren zur antistatischen Ausrüstung von Kunststoffen.

Europäisches Patentamt

# EUROPÄISCHER RECHERCHENBERICHT

0059325

Nummer der Anmeldung

EP 82 10 0674

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| A | US-A-4 204 216 (A.J. HEEGER) * Anspruch 1; Spalte 10, Zeilen 16-27 * | 1,6 | C 08 F 8/42<br>C 08 F 8/48<br>H 01 B 1/12<br>H 01 L 29/28<br>H 01 L 31/02 |
| | --- | | |
| D,A | US-A-3 092 613 (G.W. KENNERLY) * Ansprüche 1,2,6 * | 1 | |
| | ----- | | |

RECHERCHIERTE SACHGEBIETE (Int. Cl. ³)

C 08 F 8/42
C 08 F 8/48
H 01 B 1/12
H 01 L 29/28
H 01 L 31/02

Der vorliegende Recherchenbericht wurde für alle Patentansprüche erstellt.

| Recherchenort | Abschlußdatum der Recherche | Prüfer |
|---|---|---|
| DEN HAAG | 17-06-1982 | PERMENTIER W.A. |

KATEGORIE DER GENANNTEN DOKUMENTEN

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503. 03.82